# EUROPEAN PATENT APPLICATION

(11) **EP 1 976 002 A2**
(43) Date of publication of application: **01.10.2008**
(21) Application number: 07122595.7
(22) Date of filing: 07.12.2007
(51) Int. Cl.: H01L 21/8238, H01L 27/092

(54) **Semiconductor device and method for manufacturing the same**

(30) Priority: 30.03.2007 JP 2007093284
(71) Applicant: MATSUSHITA ELECTRIC INDUSTRIAL CO., LTD., Kadoma-shi, Osaka 571-8501 (JP)
(72) Inventor: Mitsuhashi, Riichiro, c/o Matsushita Electric Ind. Co., Ltd., Osaka 540-6207 (JP); Oikawa, Kota, c/o Matsushita Electric Industrial Co., Ltd., Osaka Osaka 540-6207 (JP); Barry, Osullivan, 3000 Leuven (BE); Kubicek, Stefan, 3212 Pellenberg (BE)
(74) Representative: Grünecker, Kinkeldey, Stockmair & Schwanhäusser Anwaltssozietät

(57) **Abstract**

A semiconductor device includes: a p-type active region and an n-type active region which are formed in a semiconductor substrate; a first MISFET including a first gate insulating film formed on the p-type active region and a first gate electrode formed on the first gate insulating film and including a first electrode formation film containing a metal element; and a second MISFET including a second gate insulating film formed on the n-type active region and a second gate electrode formed on the second gate insulating film and including a second electrode formation film. The second electrode formation film contains the same metal element as the first electrode formation film and has an oxygen content higher than the first electrode formation film.

## Description

### Background of the Invention

### Field of the Invention

The present invention relates to semiconductor devices, such as MISFETs and manufacturing methods thereof.

### Related Art

In recent years, semiconductor devices are being required to operate at high speed with low power consumption. In order to achieve high speed operation of the semiconductor devices, the gate capacitance of MISFETs (Metal Insulator Semiconductor Field Effect Transistors) is increased to increase the driving current. In order to increase the gate capacitance, the distance between electrodes (between a substrate and an electrode) must be reduced by reducing the thickness of the gate insulating films. In response to this demand, the physical thickness of the gate insulating films of the MISFETs are reduced now to approximately 2 nm in a case using SiON (silicon oxinitride). While, recent reduction in thickness of the gate insulating films involves a problem of gate leak current. In order to cope with this problem, the use of materials having high dielectric constants, such as an oxide containing Hf is being examined in place of the conventionally used silicon oxide (SiO₂) based materials.

Reduction in thickness of the gate insulating films involves another problem that the gate electrodes that have been made of polysilicon are depleted to lower the gate capacitance. In terms of a film thickness of a gate insulating film made of, for example, silicon oxide (SiO₂), the lowered amount of the gate capacitance in this case increases the film thickness by approximately 0.5 nm. The thinned gate insulating films inevitably involve an increase in gate leak current, but nevertheless reduction in effective thickness of the gate insulating films can be achieved without increasing the gate leak current if depletion can be suppressed. When the thickness of a SiO₂ film is reduced by 0.1 nm, leak current increases ten times or more than that before reduction in thickness. Thus, suppression of depletion of the gate electrodes is significantly effective.

In view of the foregoing, exchange of the material of the gate electrodes from polysilicon to metal causing no depletion is being examined for obviating depletion of the gate electrodes. Nevertheless, while formation of the impurity level by implantation of impurity into polysilicon enables separate formation of a p-type MISFET electrode and an n-type MISFET electrode, such separate formation is disabled with the metal.

Besides, recent semiconductor devices are required to operate at further higher speed. Therefore, lowering of threshold voltage (Vt) is an essential issue, and the p-type MISFET electrode and the n-type MISFET electrode should have work functions (WF) approximating to the band edge of silicon. Wherein, the band edge means a high WF approximating to the work function (approximately 5.2 eV) at the upper part (top edge) of the valence band of silicon in the p-side region and a low WF approximating to the work function (approximately 4.1 eV) at the bottom part (bottom edge) of the conduction band of silicon in the n-side region. The conventional semiconductor devices are so designed that the p-type MISFET and the n-type MISFET thereof have the same threshold voltage Vt by using metal having a WF corresponding to the substantial mean value between the WF in the p-side region and that in the n-side region as a common material of the p-type MISFET electrode and the n-type MISFET electrode. Such semiconductor devices will become impractical any longer.

Under the above circumstances, search for suitable metal materials for the p-type MISFET electrode and the n-type MISFET electrode are being promoted recently. No suitable metal material has been found yet because any materials having appropriate WFs at normal temperature vary in WF when they undergo high-temperature treatment, such as a source/drain regions activating step and the like, but at last, several potential candidates are found recently. Ta-based materials, such as TaC, TaN, and the like are now examined as potential candidates of the material for the n-type MISFET electrodes, as indicated in W. J. Taylor Jr., IEDM, 2006, page 625 and P. D. Kirsch, IEDM, 2006, page 629. Favorable characteristics are exhibited in a combination of a gate electrode made of a Ta-based material and a gate insulting film made of a lanthanoide-based material, such as La or the like.

On the other hand, as potential candidates as materials for the p-type MISFET electrode, noble metal, such as Pt, Ir, and the like, MoO (molybdenum oxide), and the like are proposed in C. H. Wu, IEDM, 2006, page 617 and R. Singanamalla, IEDM 2006, page 637.

In the case where the material and the compositions of the gate electrodes are different between the p-type MISFET and the n-type MISFET, formation of the p-type MISFET and the n-type MISFET on a single semiconductor substrate, for example, formation of a CMIS (Complementary Metal Insulator Semiconductor) requires a process of, for example: depositing a metal for the n-type MISFET (or the p-type MISFET) on a gate insulating film; selectively removing a part of the metal for the n-type MISFET (or the p-type MISFET) which is formed in the p-type MISFET region (or the n-type MISFET region); and then, depositing a meal for the p-type MISFET (or the n-type MISFET) on a part of the gate insulating film which is formed in the p-type MISFET region (or the n-type MISFET region), as disclosed in F. Ootsuka et al., "Extended Abstract of the 2006 International Conference on Solid State Device and Materials," Yokohama, 2006, pp. 1116-1117.

### Summary of the Invention

Most of all the above potential candidates of the material for the electrodes, however, are different in element and composition between the p-type MISFET and the n-type MISFET. In this case, employment of the above CMIS formation method requires simultaneous formation of patterns for the gate electrodes in the p-type MISFET region and the n-type MISFET region. In general, the patterns of the gate electrodes are formed by dry etching after photolithography. While, recent miniaturization of semiconductor devices results in gate lengths of 50 nm or smaller, whereby a recessed amount of polysilicon substrates after etched must be several nanometers or smaller. In the case where the elements and the compositions of the electrodes are significantly different between the p-type MISFET electrode and the n-type MISFET, it is too difficult to equalize the etching rates of the electrodes in dry etching to satisfy the aforementioned requisites for miniaturization. Further, the significant difference in element and composition may make the characteristics of the gate electrodes, such as thermal stability of the gate electrodes, stress on the gate insulating films, reactivity with the gate insulating films, and the like to be different therebetween significantly. Thus, CMIS formation might be impractical.

As materials having WFs suitable for the n-type MISFET region, TaC or TaN with a cap layer made of LaO are examined. These materials can be handled comparatively easily and can be readily used in semiconductor manufacture lines. On the other hand, as materials having WFs suitable for the p-type MISFET region, noble metal materials, such as Ru, Pt, and the like have been proposed, which might be difficult for use when taking problems of pollution into consideration.

Furthermore, the aforementioned CMIS formation method requires removal of the material of the metal-made gate electrode immediately on the gate insulating film, thereby inviting change in film thickness of the gate insulating film and reliability lowering, as disclosed in F. Ootsuka et al., "Extended Abstract of the 2006 International Conference on Solid State Device and Materials," Yokohama, 2006. Although several other processes for separately forming the p-type MISFET and the n-type MISFET may be contemplated, removal of a film formed on the gate insulating film might inevitably invite damage to the thinned gate insulating film.

In view of the foregoing, the present invention has its object of providing a semiconductor device including a metal gate electrode having a suitable work function, which is capable of high-speed operation with depletion suppressed and a manufacturing method thereof.

In order to achieve the above object, a semiconductor device in accordance with the present invention includes: a semiconductor substrate; a p-type active region and an n-type active region which are formed in the semiconductor substrate; a first MISFET including a first gate insulating film formed on the p-type active region and a first gate electrode formed on the first gate insulating film and including a first electrode formation film containing a metal element; and a second MISFET including a second gate insulating film formed on the n-type active region and a second gate electrode formed on the second gate insulating film and including a second electrode formation film containing the metal element and having an oxygen content higher than the first electrode formation film.

In the above arrangement, the first gate electrode and the second gate electrode formed on the single semiconductor substrate are made of different materials, and the electrode formation films composing the respective gate electrodes contain the same metal element. Further, the oxygen content of the second electrode formation film is higher than that of the first electrode formation film. In this case, when a material having a low work function, such as TaC or the like is used as the material of the first electrode formation film while a material having a high work function, such as TaCO or the like is used as the material of the second electrode formation film, an n-type MISFET and a p-type MISFET including gate electrodes having appropriate work functions approximating to the band edge of silicon can be formed. As a result, a semiconductor device, such as a CMIS can be attained which has high threshold voltage and capable of high-speed operation with depletion of the gate electrodes suppressed even when miniaturized.

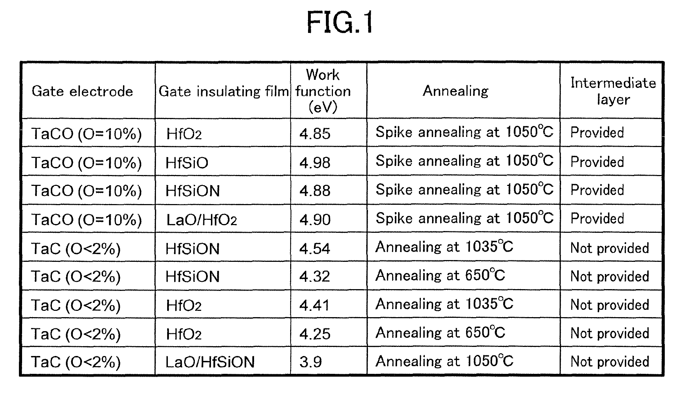

Herein, description will be given with reference to FIG. 1 to the reason why materials containing the same metal element and having oxygen contents different from each other are used as the materials of the first electrode formation film and the second electrode formation film.

FIG. **1** is a table indicating materials for a gate electrode and work functions thereof in the present invention. FIG. **1** proves that TaCO has a work function (WF) considerably higher than TaN when TaCO (Ta:C:O = 45:45:10, for example) is used as the material of the gate electrode. Referring to TaC, with no intermediate layer for anti-oxidation provided, high-temperature annealing oxidizes TaC to increase the work function thereof. From the foregoing, it is cleared that the WF varies according to a rate of oxygen contained in the material of an electrode. Further, TaCO has a high work function irrespective of a kind of the gate insulating film, which means that the work function of TaCO might be less dependent on the gate insulating film. Metal films containing Ta, C, or O have been used in the conventional semiconductor devices and are materials easily handled as the materials for the p-type MISFET electrode.

While, as also indicated in FIG. **1**, in the case where TaC is use, change in kind of the gate insulating film by, for example, providing a cap layer made of LaO on a HfSiON film can further reduce the work function. Therefore, TaC might be useful as a material of the n-type MISFET electrode.

In view of the aforementioned knowledge, it is cleared that when TaC is used as a material of the n-type MISFET electrode while TaCO is used as a material of the p-type MISFET, a CMIS can be formed which has rather low threshold voltage (which varies in proportion to the work function) and exhibits favorable characteristics. Since TaC and TaCO are the same in element other than oxygen, the same characteristics, such as the etching rate as etching characteristics and other physical characteristics might be exhibited. In consequence, the respective electrode materials can be etched simultaneously in forming the gate electrodes to suppress complication of a CMIS manufacturing process unlike the conventional CMIS manufacturing method.

It is noted that, as described above, the work function of TaC can be lowered further by using a gate insulating film containing La. There is apprehension that the use of a gate insulating film containing La in the p-type MISFET may invite lowering of the work function of the p-type MISFET electrode. In the case of TaCO, however, the use of the gate insulating film containing La hardly lowers the work function of the gate electrode, as indicated in FIG. **1****.** Thus, the use of TaC and TaCO as the materials of the respective gate electrodes can achieve respective appropriate work functions even with the use of a gate insulating film made of HfO₂, HfSiO, HfSiON, or any of them containing La.

It was additionally found that when a gate electrode of which main material contains Ta other than TaC, such as TaN, TaLaN, or the like is used as the n-type MISFET gate electrode, the use of TaCO as the material of the p-type MISFET facilitates the processing, such as etching of the gate electrodes when compared with the conventional semiconductor device manufacturing method in which a noble metal or the like is used as the material of the p-type MISFET electrode. This might be because of an effect achieved by adding oxygen to Ta. Consequently, even when an oxide which exhibits metal characteristics and contains Ta, such as TaNO having a comparatively low oxygen content, is used rather than TaCO as a material of the p-type MISFET electrode, a high work function substantially equal to that of TaCO can be achieved.

According to the result of the above study, a semiconductor device in accordance with the present invention includes a first electrode formation film containing a metal and a second electrode formation film which contains the same metal as the first electrode formation film and has an oxygen content higher than the first electrode formation film.

A semiconductor device manufacturing method in accordance with the present invention is a method for manufacturing a semiconductor device including a semiconductor substrate, a p-type active region, an n-type active region, a first MISFET including a first gate insulating film and a first gate electrode, and a second MISFET including a second gate insulating film and a second gate electrode, wherein the method includes the steps of: (a) forming a gate insulating film on the semiconductor substrate after the p-type active region and the n-type active region are formed in the semiconductor substrate; (b) forming a first electrode formation film on a part of the gate insulating film which is located on the p-type active region, the first electrode formation film containing a metal element; (c) forming a second electrode formation film on a part of the gate insulating film which is located on the n-type active region, the second electrode formation film containing the metal element and having an oxygen content higher than the first electrode formation film; and (d) removing a part of the first electrode formation film, a part of the second electrode formation film, and a part of the gate insulating film to form on the p-type active region the first gate electrode provided on the first gate insulating film and including the first electrode formation film and form on the n-type active region the second gate electrode provided on the second gate insulating film and including the second electrode formation film. Wherein, the step (b) may include the steps of: (b1) forming the first electrode formation film on each of the parts of the gate insulating film which are located on the p-type active region and the n-type active region; and (b2) removing the first electrode formation film with the part located on the p-type active region left, and the step (c) may include the steps of: (c1) forming the second electrode formation film on the first electrode formation film and the gate insulating film; and (c2) removing the second electrode formation film with the part located on the n-type active region left.

In the above method, the materials used as the materials of the first electrode formation film and the second electrode formation film contain the same meal element and have oxygen contents different from each other, and therefore, these materials have similar characteristics, such as etching characteristics and other physical characteristics. Accordingly, in the semiconductor device manufacturing method in accordance with the present invention, the first electrode formation film and the second electrode formation film can be etched comparatively easily in patterning the first gate electrode and the second gate electrode in the predetermined regions in the step (d). Further, change in oxygen content changes the work functions of the first electrode formation film and the second electrode formation film, thereby achieving simultaneous formation of the first MISFET and the second MISFET having conductivity types different from each other in the single semiconductor substrate.

Furthermore, in the semiconductor device manufacturing method in accordance with the present invention, the step (b) may include the step of forming the first electrode formation film on each of the parts of the gate insulating film which are located on the p-type active region and the n-type active region, and the step (c) may include the step of oxidizing a part of the first electrode formation film which is located on the n-type active region to form the second electrode formation film containing the metal element and having an oxygen content higher than the first electrode formation film. Wherein, in the step (c), the part of the first electrode formation film which is located on the n-type active region may be oxidized by performing thermal treatment under an oxygen atmosphere.

In the above method, the second electrode formation film is formed by oxidizing the first electrode formation film by thermal treatment in the step (c). Formation of the second electrode formation film formed thereby eliminates the need to remove the first electrode formation film immediately on the gate electrode to suppress damage to the gate insulating film and change in film thickness of the gate insulating film in a dry etching process and the like. As a result, employment of the semiconductor device manufacturing method in accordance with the present invention achieves manufacture of a highly reliable semiconductor device even when miniaturized.

In addition, in the sep (c), the part of the first electrode formation film which is located on the n-type active region may be oxidized by injecting an oxygen ion. This method achieves formation of the second electrode formation film likewise the above described oxidation by thermal treatment with no damage to the gate insulating film invited, achieving comparatively easy manufacture of a highly reliable semiconductor device.

### Brief Description of the Drawings

FIG. **1** is a table indicating materials for gate electrodes and work functions in accordance with the present invention.
FIG. **2A** to FIG. **2E** are sectional views showing respective steps of a semiconductor device manufacturing method in accordance with Embodiment 1 of the present invention.
FIG. **3A** to FIG. **3E** are sectional views showing respective steps of the semiconductor device manufacturing method in accordance with Embodiment 1.
FIG. **4A** to FIG. **4D** are sectional views showing respective steps of the semiconductor device manufacturing method in accordance with Embodiment 1.
FIG. **5A** to FIG. **5E** are sectional views showing respective steps of a semiconductor device manufacturing method in accordance with Embodiment 2 of the present invention.
FIG. **6A** to FIG. **6E** are sectional views showing respective steps of the semiconductor device manufacturing method in accordance with Embodiment 2.
FIG. **7** is a sectional view showing a step of the semiconductor device manufacturing method in accordance with Embodiment 2.
FIG. **8A** to FIG. **8D** are sectional views showing respective steps of a semiconductor device manufacturing method in accordance with Embodiment 3 of the present invention.
FIG. **9A** to FIG. **9D** are sectional views showing respective steps of the semiconductor device manufacturing method in accordance with Embodiment 3.
FIG. **10** is a sectional view showing a step of the semiconductor device manufacturing method in accordance with Embodiment 3.

### Description of Preferred Embodiments

### (Embodiment 1)

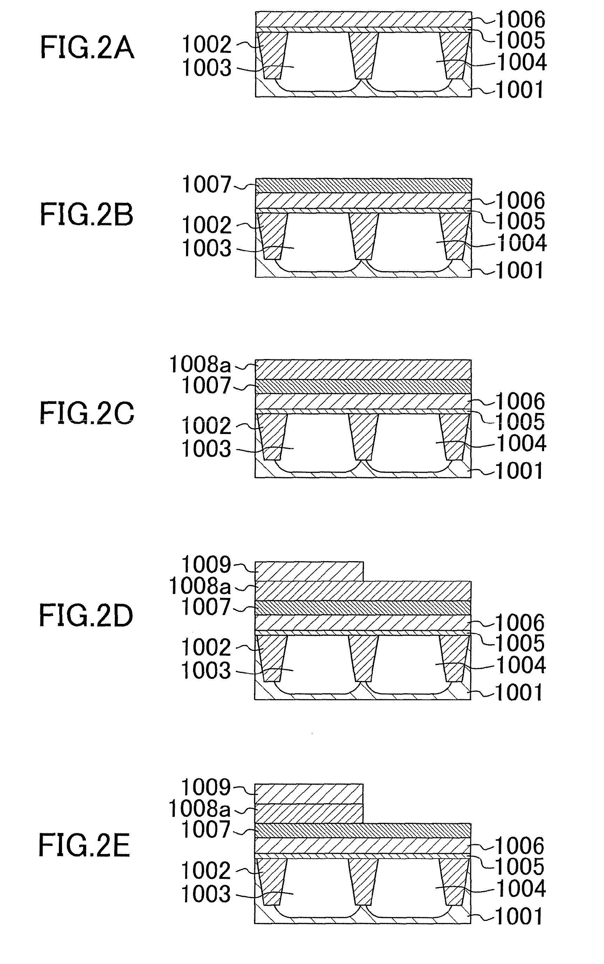

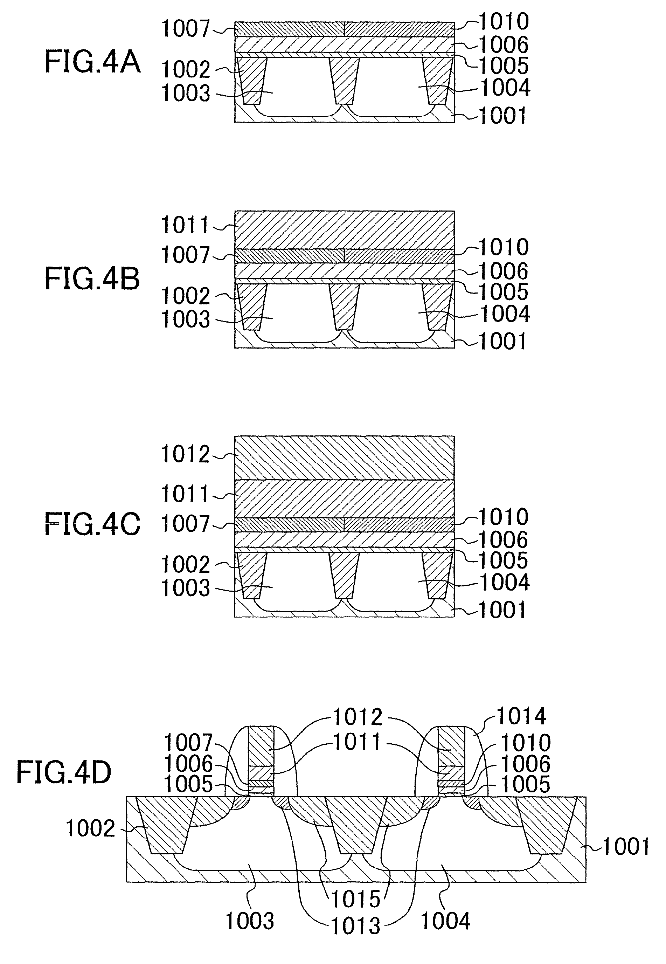

A semiconductor device and a method for manufacturing it in accordance with Embodiment 1 of the present invention will be described below with reference to the drawings. FIG. **2** to FIG. **4** are sectional views showing respective steps of the semiconductor device manufacturing method in accordance with the present embodiment. First of all, a structure of the semiconductor device in accordance with the present embodiment will be described with reference to FIG. **4D**.

As shown in FIG. **4D**, the semiconductor device in accordance with the present embodiment includes: a semiconductor substrate **1001** made of, for example, silicon; a p-type active region **1003** and an n-type active region **1004** formed in the semiconductor substrate **1001**; an isolation layer **1002** for isolating the p-type active region **1003** and the n-type active region **1004**; and source/drain regions **1015** and extension regions **1013** formed in the p-type active region **1003** and the n-type active region **1004**.

Further, the semiconductor device of the present embodiment includes an underlying film **1005**, a gate insulating film **1006**, a first electrode formation film **1007**, an intermediate film **1011**, and a third electrode formation film **1012**. The underlying film **1005,** which is made of SiO₂ or the like, is formed on a region of the semiconductor substrate **1001** which is located between two adjacent extension regions **1013** in the p-type active region **1003** as viewed in plan. The gate insulating film **1006**, which is made of HfSiON or the like, is formed on the underlying film **1005**. The first electrode formation film **1007**, which is made of TaC or the like, is formed on the gate insulating film **1006**. The intermediate film **1011**, which is made of TaN or the like, is formed on the first electrode formation film **1007**. The third electrode formation film **1012**, which is made of polysilicon or the like, is formed on the intermediate film **1011**. In other words, in the p-type active region **1003** of the semiconductor substrate **1001**, an n-type MISFET is formed which is composed of the underlying film **1005**, the gate insulating film **1006**, a first gate electrode including the first electrode formation film **1007**, the intermediate film **1011**, and the third electrode formation film **1012**, the source/drain regions **1015**, and the extension regions **1013**.

As well, the semiconductor device of the present embodiment includes, in the n-type active region **1004** of the semiconductor substrate **1001**, the underlying film **1005**, the gate insulating film **1006**, a second electrode formation film **1010**, the intermediate film **1011**, and the third electrode formation film **1012**. The underlying film **1005**, which is made of SiO₂ or the like, is formed on a region of the semiconductor substrate **1001** which is located between two adjacent extension regions **1013** in the n-type active region **1004** as viewed in plan. The gate insulating film **1006**, which is made of HfSiON or the like, is formed on the underlying film **1005**. The second electrode formation film **1010**, which is made of TaCO or the like, is formed on the gate insulating film **1006**. The intermediate film **1011**, which is made of TaN or the like, is formed on the second electrode formation film **1010**. The third electrode formation film **1012**, which is made of polysilicon or the like, is formed on the intermediate film **1011**. In other words, in the n-type active region **1004** of the semiconductor substrate **1001**, a p-type MISFET is formed which is composed of the underlying film **1005**, the gate insulating film **1006**, a second gate electrode including the second electrode formation film **1010**, the intermediate film **1011**, and the third electrode formation film **1012**, the source/drain regions **1015**, and the extension regions **1013**.

Sidewalls **1014** as composition members of the respective MISFETs are formed on the side faces of the underlying film **1005**, the gate insulating film **1006**, and the first gate electrode and on the side faces of the underlying film **1005**, the gate insulating film **1006**, and the second gate electrode.

In the semiconductor device of the present embodiment, the first gate electrode and the second gate electrode formed on the single semiconductor substrate **1001** are made of materials different from each other and are formed of the electrode formation films containing the same metal element (Ta). Further, the oxygen content of the second electrode formation film **1010** composing the second gate electrode is larger than that of the first gate electrode formation film **1007** composing the first gate electrode. According to the above arrangement, namely, when TaC having a low work function is used as the material of the first electrode formation film **1007** while TaCO having a high work function is used as the material of the second electrode formation film **1010**, a semiconductor device can be attained which includes an n-type MISFET and a p-type MISFET including the gate electrodes made of materials of which work functions are comparatively close to the band edge of silicon. As a result, a semiconductor device such as a CMIS having low threshold voltage and capable of high-speed operation with depletion of the gate electrodes suppressed can be attained even when miniaturized.

Further, in the semiconductor device of the present embodiment, the third electrode formation film **1012** is formed on the first gate electrode and the second gate electrode which are formed in the n-type MISFET and the p-type MISFET, respectively, thereby contemplating lowering of the resistances of the first gate electrode and the second gate electrode.

In the semiconductor device of the present embodiment, the intermediate film **1011** is provided between the first electrode formation film **1007** and the third electrode formation film **1012** and between the second electrode formation film **1010** and the third electrode formation film **1012**. Even if the first electrode formation film **1007** is made of a material which is liable to be oxidize, the intermediate film **1011** made of TaN or the like serves as an anti-oxidation film.

The semiconductor device manufacturing method in accordance with the present embodiment will be described next with reference to FIG. **2** to FIG. **4**.

First, as shown in FIG. **2A**, the p-type active region **1003**, the n-type active region **1004,** and the isolation layer **1002** for separating them are formed in the semiconductor substrate **1001**. RTO (Rapid Thermal Oxidation) using an oxygen gas is performed to deposit the underlying layer **1005** made of, for example, SiO₂ and having a film thickness of approximately 1 nm on the semiconductor substrate **1001**. Any suitable gas other than the oxygen gas may be used. Thermal treatment using a heating furnace may be performed. The material of the underlying film **1005** may be SiON, a chemical oxide, or the like. Then, a HFSiO film having, for example, a high dielectric constant and a thickness of 2.5 nm is deposited by MOCVD (Metal Organic Chemical Vapor Deposition), and the thus deposited HfSiO film is plasma-nitrided to form the gate insulating film **1006** formed of a HfSiON film. The gate insulating film **1006** may be made of HfO₂ or Hfsi, or may be formed of any other suitable Hf-based insulating film containing La. Alternatively, any suitable high dielectric, such as Al₂O₃, ZrO₂, LaO, DyO, ScO, or the like may be used, or the gate insulating film **1006** may be made of SiO₂ or SiON other than the high dielectrics according to needs. Rather than MOCVD, CVD (Chemical Vapor Deposition), PVD (Physical Vapor Deposition) or the like may be performed.

Next, as shown in FIG. **2B**, the first electrode formation film **1007** made of TaC or the like is deposited on the gate insulating film **1006**. As the material of the first electrode formation film **1007**, TaLaO, TaN, or the like may be used, wherein a metal material containing Ta is more preferable. The film thickness of the first electrode formation film **1007**, which can be changed according to the kind of a material of the first electrode formation film **1007** and the peripheral process, is preferably 10 nm or smaller.

Subsequently, as shown in FIG. **2C****,** a hard mask **1008a** made of SiO₂ or the like is formed on the protection film **1007**. Then, a resist **1009** is formed on the hard mask 1008a, and a part of the resist **1009** which is located above the n-type active region **1004** is removed by photolithography, as shown in FIG. **2D**.

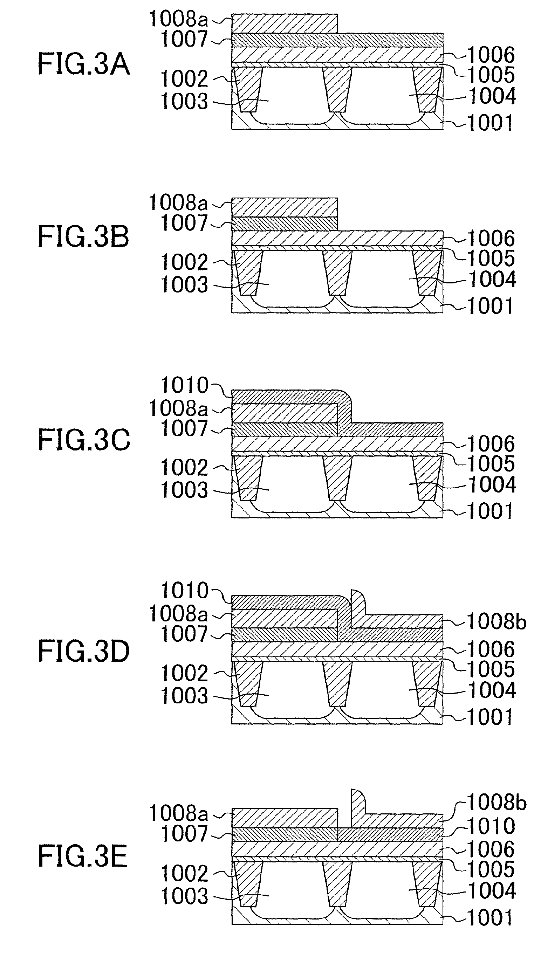

Thereafter, as shown in FIG. **2E**, etching using the resist **1009** remaining above the p-type active region **1003** as a mask is performed to remove a part of the hard mask **1008a** which is located above the n-type active region **1004**. Then, as shown in FIG. **3A**, the resist **1009** is removed by ashing to thus leave selectively a part of the hard mask 1008a which is located above the p-type active region **1003**.

Next, as shown in FIG. **3B**, etching using the hard mask **1008a** remaining above the p-type active region **1003** as a mask is performed to remove a part of the first electrode formation film **1007** which is located above the n-type active region **1004**.

Subsequently, as shown in FIG. **3C**, the second electrode formation film **1010** made of TaCO or the like and having a thickness of 10 nm is deposited on the first electrode formation film **1007** and the hard mask **1008a.** Other than TaCO, the material of the second electrode formation film **1010** may be an oxide of the first electrode formation film **1007** or an oxide of a material containing the same element as that of the first electrode formation film **1007**, such as TaLaNO, TaNO, or the like. The film thickness of the second electrode formation film **1010**, which can be changed according to the kind of a material of the second electrode formation film **1010** and the peripheral process, is preferably 5 nm or smaller.

Thereafter, a hard mask **1008b** made of, for example, SiO₂ is formed on the second electrode formation film **1010**. Then, a part of the hard mask **1008b** which is located above the p-type active region **1003** is removed by photolithography, as shown in FIG. **3D**.

Next, as shown in FIG. **3E**, the second electrode formation film **1010** is removed by dry etching or the like using the hard mask **1008b** formed above the n-type active region **1004** as a mask. Then, the hard masks **1008a** and **1008b** are removed with the use of hydrofluoric acid or the like, as shown in FIG. **4A**. Thus, the first electrode formation film **1007** and the second electrode formation film **1010** are formed above the p-type active region **1003** and the n-type active region **1004**, respectively.

Subsequently, as shown in FIG. **4B**, the intermediate film **1011**, for example, made of TaN or the like and having a thickness of 5 nm is deposited on the first electrode formation film **1007** and the second electrode formation film **1010**. The material of the intermediate film **1011** is not limited to TaN, and any other suitable material may be used. In the semiconductor device manufacturing method in the present embodiment, TaC, which is liable to be oxidized at the interface thereof, is used as the material of the first electrode formation film **1007**, and therefore, the intermediate film **1011** is provided as an anti-oxidation film. Accordingly, in the case where a less oxidized material, such as TaN or the like is used as the material of the first electrode formation film **1007**, the intermediate film **1011** may not be provided.

Thereafter, as shown in FIG. **4C**, the third electrode formation film **1012**, for example, made of polysilicon and having a thickness of 100 nm is deposited on the intermediate film **1011**, and then, an impurity is implanted into the third electrode formation film **1012**.

Next, as shown in FIG. **4D**, the underlying film **1005**, the gate insulating film **1006**, the first electrode formation film **1007**, the second electrode formation film **1010**, the intermediate film **1011**, and the third electrode formation film **1012** are etched by photolithography and RIE (Reactive Ion Etching) so that parts of each of them are left on predetermined regions of the p-type active region **1003** and the n-type active region **1004**. Then, the extension regions **1013**, the sidewalls **1014**, the source/drain regions **1015** are formed, and the impurity implanted in the source/drain regions **1015** are activated to thus form the n-type MISFET and the p-type MISFET in the p-type active region **1003** and the n-type active region **1004**, respectively. In order to activate the impurity in the source/drain regions **1015**, spike annealing at a temperature of, for example, 1050 °C is performed.

By the above method, the n-type MISFET is formed in the p-type active region **1003,** wherein the n-type MISFET includes the underlying film **1005,** the gate insulating film 1006, the first gate electrode composed of the first electrode formation film **1007**, the intermediate film **1011**, and the third electrode film **1012**, the sidewalls **1014**, the source/drain regions **1015**, and the extension regions **1013**. While in the n-type active region **1004**, the p-type MISFET is formed which includes the underlying film **1005**, the gate insulating film **1006**, the second gate electrode composed of the second electrode formation film **1010**, the intermediate film **1011**, and the third electrode film **1012**, the sidewalls **1014**, the source/drain regions **1015**, and the extension regions **1013**.

In the semiconductor device manufacturing method of the present embodiment, the material (TaC) of the first electrode formation film **1007** and that (TaCo) of the second electrode formation film **1010** contain the same metal element (Ta) and have oxygen contents different from each other. The materials, which contain the same material other than oxygen, might exhibit the same characteristics, such as the etching characteristics and other physical characteristics. Hence, according to the semiconductor device manufacturing method of the present embodiment, the first electrode formation film **1007** and the second electrode formation film **1010** can be etched comparatively easily in patterning the gate electrodes in the predetermined regions in the step shown in FIG. **4D**, thereby achieving simultaneous formation of the p-type MISFET and the n-type MISFET on the semiconductor substrate **1001**.

The gate insulating film **1006** is made of HfSiON as one example in the semiconductor device manufacturing method of the present embodiment. While, TaCO used as the material of the gate electrode of the p-type MISFET exhibits a high work function irrespective of the kind of a gate insulating film with less variation in WF with respect to the gate insulating film, as described above (see FIG. **1**). In the case using TaCO and TaC as the first and second electrode formation films **1007, 1010,** respectively, the gate electrode of the p-type MISFET and the gate electrode of the n-type MISFET can exhibit favorable WFs even when a HfO₂ film with a LaO-made cape layer, HfO₂ film, or any other insulating film is used as the gate insulating film **1006**. Further, the first electrode formation film 1007 may be made of any other suitable material which contains the same element as the second electrode formation film **1010** (TaCO), which is easily processed, for example, by etching, and which has a low WF, such as TaN, TaC, or the like.

It is noted that in the semiconductor device and the manufacturing method thereof of the present embodiment, the oxygen content of the first electrode formation film **1007** is preferably 2 % or lower. It is also preferable to set the oxygen content of the second electrode formation film **1010** between 10 % and 30 %, both inclusive because a sufficient WF increasing effect in the presence of oxygen can be achieved while an increase in resistance of the second electrode formation film **1010** can be suppressed. In addition, etching and the like for forming the gate electrodes by processing the first electrode formation film **1007** and the second electrode formation film **1010** can be done comparatively easily.

In addition, the second electrode formation film **1010** is formed by CVD in the semiconductor device manufacturing method of the present embodiment, achieving easy adjustment of the oxygen content of the second electrode formation film **1010** to a desired value.

### (Embodiment 2)

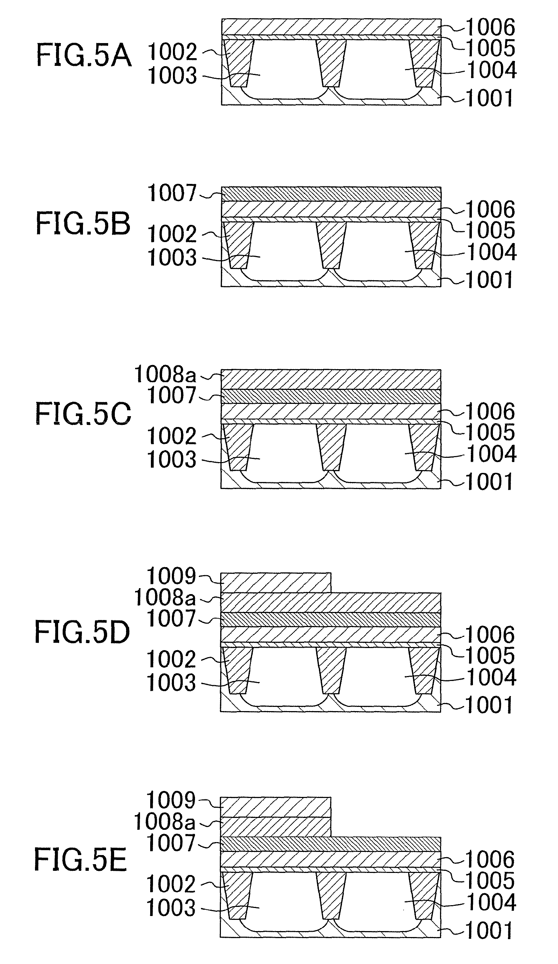

A semiconductor device and a manufacturing method thereof in accordance with Embodiment 2 will be described below with reference to the drawings. FIG. **5** to FIG. **7** are sectional views showing respective steps of the semiconductor device manufacturing method in accordance with Embodiment 2 of the present invention. The semiconductor device manufacturing method in accordance with the present embodiment is a method for manufacturing the semiconductor device of Embodiment 1 by a manner different from that of Embodiment 1. Herein, the same parts as in the semiconductor device manufacturing method of Embodiment 1 will be described in a simplified manner.

First, as shown in FIG. **5A****,** the p-type active region **1003,** the n-type active region **1004**, and the isolation layer **1002** for separating them are formed in the semiconductor substrate **1001.** Then, the underlying film **1005** made of, for example, SiO₂ and having a thickness of approximately 1 nm is deposited on the semiconductor substrate **1001** by RTO (Rapid Thermal Oxidation) using an oxygen gas. Any suitable gas other than the oxygen gas may be used. Further, thermal treatment using a heating furnace may be performed. The material of the underlying film **1005** may be SiON, a chemical oxide, or the like. Then, a HfSiO film, for example, having a high dielectric and a thickness of 2.5 nm is deposited by MOCVD (Metal Organic Chemical Vapor Deposition), and the thus deposited HfSiO film is plasma-nitrided to form the gate insulating film 1006 formed of a HfSiON film. The material of the gate insulating film **1006** may be made of HfO₂ or HfSiO, or may be formed of any other suitable Hf-based insulating film containing La. Alternatively, any suitable high dielectric, such as Al₂O₃, ZrO₂, HfO₂, LaO, DyO, ScO, or the like may be used, or SiO₂ or SiON other than high dielectrics may be used according to needs. Rather than MOCVD, another film formation method may be employed, such as CVD (Chemical Vapor Deposition), PVD (Physical Vapor Deposition), or the like.

Next, as shown in FIG. **5B****,** the first electrode formation film **1007** made of TaC or the like is deposited on the gate insulating film **1006**. The film thickness of the first electrode formation film **1007**, which can be changed appropriately according to the kind a material of the first electrode formation film **1007** and the peripheral process, is preferably 10 nm or smaller.

Subsequently, as shown in FIG. **5C****,** the hard mask **1008a** made of SiO₂ or the like is formed on the first electrode formation film **1007**. Then, a resist **1009** is formed on the hard mask **1008a**, and a part of the resist **1009** which is located above the n-type active region **1004** is removed by photolithography, as shown in FIG. **5D****.**

Thereafter, as shown in FIG. **5E****,** etching using the resist **1009** remaining above the p-type active region **1003** as a mask is performed to remove a part of the hard mask **1008a** which is located above the n-type active region **1004**. Then, the resist **1009** is removed by ashing to thus form the hard mask **1008a** above the p-type active region **1003** selectively.

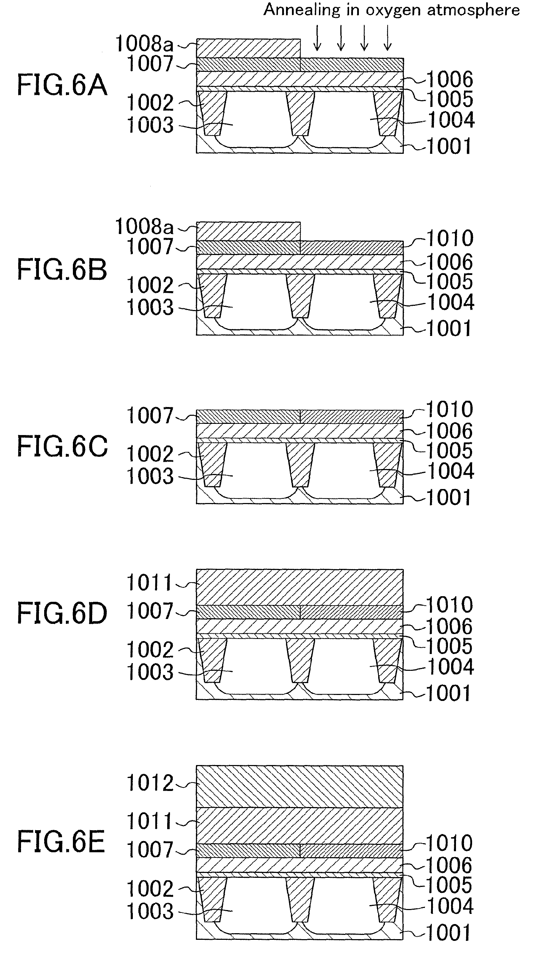

Next, as shown in FIG. **6A**, annealing at a high temperature of approximately 800 °C to 1000 °C is performed on the semiconductor substrate **1001** in an oxygen atmosphere. Without the hard mask **1008**, a part of the TaC-made first electrode formation film **1007** which is located above the n-type active region **1004** is exposed, thereby being exposed in the oxygen atmosphere in annealing to be oxidized. This forms the second electrode formation film **1010** made of TaCO, as shown in FIG. **6B****.** Then, as shown in FIG. **6**C, the hard mask **1008a** is removed with the use of hydrofluoric acid or the like. Thus, the first electrode formation film **1007** and the second electrode formation film **1010** are formed above the p-type active region **1003** and the n-type active region **1004**, respectively.

Subsequently, as shown in FIG. **6D**, the intermediate film **1011**, for example, made of TaN or the like and having a thickness of 5 nm is deposited on the first electrode formation film **1007** and the second electrode formation film **1010**. The material of the intermediate film **1011** is not limited to TaN, and any other suitable material can be used. In the semiconductor device manufacturing method of the present embodiment, TaC, which is liable to be oxidized at the interface thereof, is used as the material of the first electrode formation film **1007,** and therefore, the intermediate film **1011** is provided as an anti-oxidation film. Accordingly, in the case using a less oxidized material, such as TaN or the like as the material of the first electrode formation film 1007, the intermediate film **1011** may not be provided.

Thereafter, as shown in FIG. **6E****,** the third electrode formation film **1012,** for example, made of polysilicon and having a thickness of 100 nm is deposited on the intermediate film **1011**, and then, an impurity is implanted into the third electrode formation film **1012**.

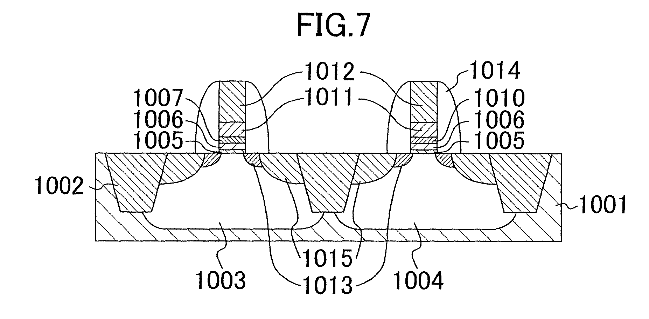

Next, as shown in FIG. **7**, the underlying film **1005**, the gate insulating film **1006**, the first electrode formation film **1007**, the second electrode formation film **1010**, the intermediate film **1011**, and the third electrode formation film **1012** are etched by photolithography and RIE (Reactive Ion Etching) so that pants of each of them are left on the predetermined regions of the p-type active region **1003** and the n-type active region **1004**. Then, the extension regions **1013**, the sidewalls **1014**, the source/drain regions **1015** are formed, and the impurity implanted in the source/drain regions **1015** are activated to thus form the n-type MISFET and the p-type MISFET in the p-type active region **1003** and the n-type active region **1004**, respectively. In order to activate the impurity in the source/drain regions **1015**, spike annealing at a temperature of, for example, 1050 °C is performed.

By the above method, the n-type MISFET is formed in the p-type active region **1003**, wherein the n-type MISFET includes the underlying film 1005, the gate insulating film **1006**, the first gate electrode composed of the first electrode formation film **1007**, the intermediate film **1011**, and the third electrode film **1012**, the sidewalls **1014**, the source/drain regions **1015**, and the extension regions **1013**. While in the n-type active region **1004**, the p-type MISFET is formed which includes the underlying film **1005**, the gate insulating film **1006**, the second gate electrode composed of the second electrode formation film **1010**, the intermediate film **1011**, and the third electrode film **1012**, the sidewalls **1014**, the source/drain regions **1015**, and the extension regions **1013**.

One of the significant features in the semiconductor device manufacturing method of the present embodiment lies in that the second electrode formation film **1010** is formed by oxidizing the first electrode formation film **1007** in the step shown in FIG. **6A**. This method eliminates the need to remove a metal material (the first electrode formation film **1007)** immediately on the gate insulating film **1006** for forming the second electrode formation film **1010**, and accordingly, damage to the gate insulating film **1006** and change in film thickness of the gate insulating film **1006**, which are caused by dry etching and the like, can be suppressed. As a result, the semiconductor device manufacturing method of the present embodiment attains a highly reliable semiconductor device even when miniaturized.

The semiconductor device manufacturing method of the present embodiment achieves, similarly to that of Embodiment 1, simultaneous formation of an n-type MISFET and a p-type MISFET each including a gate electrode having an appropriate work function, thereby leading to attainment of a semiconductor device, such as a CMIS, having low threshold voltage and capable of high-speed operation with depletion of the gate electrodes suppressed even when miniaturized.

Unlike the semiconductor device manufacturing method of Embodiment 1, only the first electrode formation film **1007** is prepared with the need to deposit the second electrode formation film **1010** eliminated in the semiconductor device manufacturing method of the present embodiment, and accordingly, the semiconductor device shown in FIG. **7** can be manufactured comparatively easily.

### (Embodiment 3)

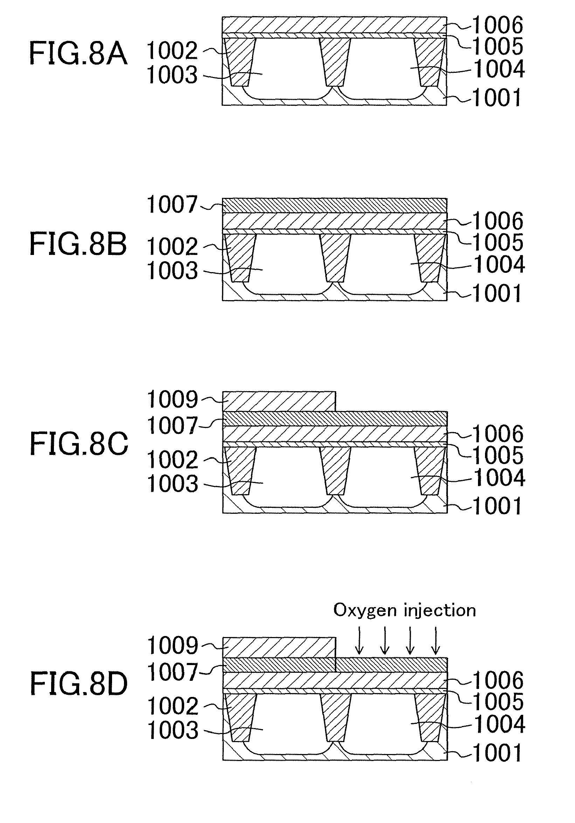

A semiconductor device and a manufacturing method thereof in accordance with Embodiment 3 will be described below with reference to the drawings. FIG. **8** to FIG. **10** are sectional views showing respective steps of the semiconductor device manufacturing method in accordance with Embodiment 3 of the present invention. The semiconductor device manufacturing method in accordance with the present embodiment is a method for manufacturing the semiconductor device of Embodiment 1 by a manner different from those of Embodiment 1 and Embodiment 2. Herein, the same parts as in the semiconductor device manufacturing method of Embodiment 1 will be described in a simplified manner.

First, as shown in FIG. **8A****,** the p-type active region **1003**, the n-type active region **1004**, and the isolation layer **1002** for separating them are formed in the semiconductor substrate **1001.** Then, the underlying film **1005** made of, for example, SiO₂ and having a thickness of approximately 1 nm is deposited on the semiconductor substrate **1001** by RTO (Rapid Thermal Oxidation) using an oxygen gas. Any suitable gas other than the oxygen gas may be used. Further, thermal treatment using a heating furnace may be performed. The material of the underlying film **1005** may be SiON, a chemical oxide, or the like. Then, a HfSiO film, for example, having a high dielectric and a thickness of 2.5 nm is deposited by MOCVD (Metal Organic Chemical Vapor Deposition), and the thus deposited HfSiO film is plasma-nitrided to form the gate insulating film **1006** formed of a HfSiON film. The gate insulating film **1006** may be made of HfO₂ or HfSiO, or may be formed of any other suitable Hf-based insulating film containing La. Alternatively, any suitable high dielectric, such as Al₂O₃, ZrO₂, HfO₂, LaO, DyO, ScO, or the like may be used, or SiO₂ or SiON other than high dielectrics may be used according to needs. Rather than MOCVD, another film formation method may be employed, such as CVD (Chemical Vapor Deposition), PVD (Physical Vapor Deposition), or the like.

Next, as shown in FIG. **8B****,** the first electrode formation film **1007** made of TaC or the like is deposited on the gate insulating film **1006**. The film thickness of the first electrode formation film **1007**, which can be changed appropriately according to the kind of a material of the first electrode formation film **1007** and the peripheral process, is preferably 10 nm or smaller.

Subsequently, the resist **1009** is formed on the first electrode formation film **1007**, and then, a part of the resist **1009** which is located above the n-type active region **1004** is removed by photolithography, as shown in FIG. **8C**.

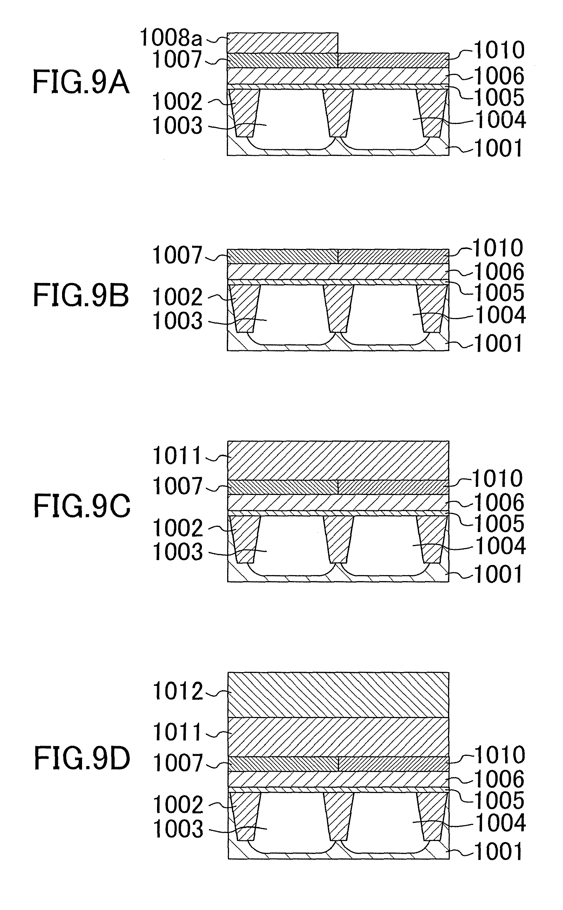

Thereafter, as shown in FIG. **8D**, oxygen is injected in the form of ion beam with the use of the resist **1009** located above the p-type active region **1003** as a mask. Without the hard mask **1008**, a part of the first electrode formation film **1007** which is located above the n-type active region **1004** is exposed, thereby being subjected to direct exposure by the oxygen ion beam in injection to be oxidized. This forms the second electrode formation film **1010** made of TaCO, as shown in FIG. **9A****.** Then, as shown in FIG. **9B**, the resist **1009** is removed by ashing. As a result, the first electrode formation film **1007** and the second electrode formation film **1010** are formed above the p-type active region **1003** and the n-type active region **1004**, respectively.

Next, as shown in FIG. **9C**, the intermediate film **1011**, for example, made of TaN and having a film thickness of 5 nm is deposited on the first electrode formation film **1007** and the second electrode formation film **1010.** The material of the intermediate film **1011** is not limited to TaN, and any other suitable material may be used. In the semiconductor device manufacturing method of the present embodiment, TaC, which is liable to be oxidized at the interface thereof, is used as the material of the first electrode formation film **1007**, and therefore, the intermediate film **1011** is provided as an anti-oxidation film. Accordingly, in the case using a less oxidized material, such as TaN or the like as the material of the first electrode formation film **1007**, the intermediate film **1011** may not be provided.

Subsequently, as shown in FIG. **9D****,** the third electrode formation film **1012**, for example, made of polysilicon and having a thickness of 100 nm is deposited on the intermediate film **1011**, and then, an impurity is implanted into the third electrode formation film **1012**.

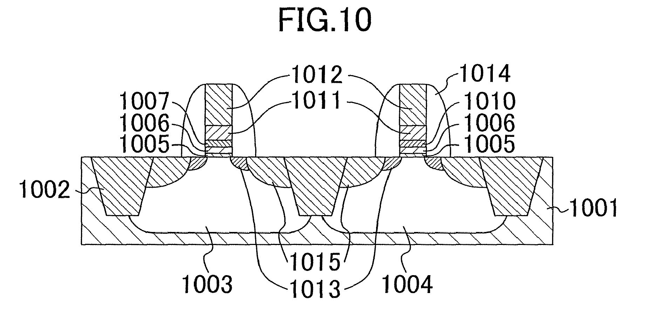

Thereafter, as shown in FIG. **10**, the underlying film **1005**, the gate insulating film **1006**, the first electrode formation film **1007**, the second electrode formation film **1010**, the intermediate film **1011**, and the third electrode formation film **1012** are etched by photolithography and RIE (Reactive Ion Etching) so that parts of each of them are left on the predetermined regions of the p-type active region **1003** and the n-type active region **1004**. Then, the extension regions **1013**, the sidewalls **1014**, the source/drain regions **1015** are formed, and the impurity implanted in the source/drain regions **1015** are activated to thus form the n-type MISFET and the p-type MISFET in the p-type active region **1003** and the n-type active region **1004**, respectively. In order to activate the impurity in the source/drain regions **1015**, spike annealing at a temperature of, for example, 1050 °C is performed.

By the above method, the n-type MISFET is formed in the p-type active region **1003**, wherein the n-type MISFET includes the underlying film **1005**, the gate insulating film **1006**, the first gate electrode composed of the first electrode formation film **1007**, the intermediate film **1011**, and the third electrode film **1012**, the sidewalls **1014**, the source/drain regions **1015**, and the extension regions **1013**. While in the n-type active region **1004**, the p-type MISFET is formed which includes the underlying film **1005**, the gate insulating film **1006**, the second gate electrode composed of the second electrode formation film **1010**, the intermediate film **1011**, and the third electrode film **1012**, the sidewalls **1014**, the source/drain regions **1015**, and the extension regions **1013**.

One of the significant features of the present embodiment lies in that the second electrode formation film **1010** is formed in such a manner that the first electrode formation film **1007** formed above the n-type active region **1004** is oxidized by injecting an oxygen ion in the step shown in FIG. **8D**. This method achieves formation of each gate electrode formation film with no damage to the gate insulating film **1006** invited, similarly to the semiconductor device manufacturing method of Embodiment 2, thereby leading to attainment of a highly reliable semiconductor device even when miniaturized.

Further, the semiconductor device manufacturing method of the present embodiment employs ion injection as an oxidation method to eliminate the need to form the hard mask **1008a** for thermal treatment, as in the semiconductor device manufacturing method of Embodiment 2, which means simplification of the semiconductor device manufacturing process.

Polysilicon in which an impurity is implanted is used as the material of the third electrode formation film **1012** in Embodiment 1, Embodiment 2, and Embodiment 3. When a metal, such as tungsten, a meal silicide (titanium silicide, cobalt silicide, or nickel silicide) or the like is used as the material of the third electrode formation film **1012**, further high-speed operation of the semiconductor device can be achieved.

Each of the semiconductor device manufacturing methods of the above embodiments is directed to a semiconductor device including the p-type active region **1003** and the n-type active region **1004** in the single semiconductor substrate **1001**. Nevertheless, the present invention is not limited thereto and is applicable to a semiconductor device in which a first MISFET and a second MISFET including gate electrodes made of different metal materials are formed in a single semiconductor substrate.

In addition, each of the semiconductor device manufacturing methods of the above embodiments uses a silicon substrate as the semiconductor substrate 1001, but the present invention is not limited thereto. A substrate made of any other suitable material may be used. For example, a SOI (Semiconductor Oxide Insulator) substrate or a substrate made of mixed crystal, such as a GaAs substrate, an InP substrate, or the like may be used.

As described above, the semiconductor device and the manufacturing methods thereof in accordance with the present invention are useful for enhancing the drivability of miniaturized CMISs and the like.

## Claims

1. A semiconductor device, comprising:
a semiconductor substrate;
a p-type active region and an n-type active region which are formed in the semiconductor substrate;
a first MISFET including a first gate insulating film formed on the p-type active region and a first gate electrode formed on the first gate insulating film and including a first electrode formation film containing a metal element; and
a second MISFET including a second gate insulating film formed on the n-type active region and a second gate electrode formed on the second gate insulating film and including a second electrode formation film containing the metal element and having an oxygen content higher than the first electrode formation film.

2. The semiconductor device of Claim 1,
wherein the first electrode formation film has a work function smaller than the second electrode formation film.

3. The semiconductor device of Claim 1 or 2,
wherein the metal element is Ta.

4. The semiconductor device of Claim 3,
wherein the second electrode formation film further contains C.

5. The semiconductor device of Claim 4,
wherein the first electrode formation film further contains C.

6. The semiconductor device of any one of Claims 1 to 5,
wherein the first gate insulating film and the second gate insulating film contain at least one selected from the group consisting of HfO₂, HfSiO, and HfSiON.

7. The semiconductor device of any one of Claims 1 to 5,
wherein the first gate insulating film and the second gate insulating film contain La.

8. The semiconductor device of any one of Claims 1 to 5,
wherein the first gate insulating film and the second gate insulating film contain Zr.

9. The semiconductor device of any one of Claims 1 to 8,
wherein an oxygen content of the first electrode formation film is 2 % or lower, and the oxygen content of the second electrode formation film is in a range between 10 % and 30 %, both inclusive.

10. The semiconductor device of any one of Claims 1 to 9,
wherein the first gate electrode further includes a third electrode formation film formed on or above the first electrode formation film, and
the second gate electrode further includes a fourth electrode formation film formed on or above the second electrode formation film.

11. The semiconductor device of Claim 10,
wherein at least one of the third electrode formation film and the fourth electrode formation film contains metal.

12. The semiconductor device of Claim 10 or 11,
wherein the first gate electrode further includes an intermediate film formed between the first electrode formation film and the third electrode formation film.

13. A method for manufacturing a semiconductor device including a semiconductor substrate, a p-type active region, an n-type active region, a first MISFET including a first gate insulating film and a first gate electrode, and a second MISFET including a second gate insulating film and a second gate electrode, the method comprising the steps of:
(a) forming a gate insulating film on the semiconductor substrate after the p-type active region and the n-type active region are formed in the semiconductor substrate;
(b) forming a first electrode formation film on a part of the gate insulating film which is located on the p-type active region, the first electrode formation film containing a metal element;
(c) forming a second electrode formation film on a part of the gate insulating film which is located on the n-type active region, the second electrode formation film containing the metal element and having an oxygen content higher than the first electrode formation film; and
(d) removing a part of the first electrode formation film, a part of the second electrode formation film, and a part of the gate insulating film to form on the p-type active region the first gate electrode provided on the first gate insulating film and including the first electrode formation film and form on the n-type active region the second gate electrode provided on the second gate insulating film and including the second electrode formation film.

14. The semiconductor device manufacturing method of Claim 13,
wherein the step (b) includes the steps of:
(b1) forming the first electrode formation film on each of the parts of the gate insulating film which are located on the p-type active region and the n-type active region; and
(b2) removing the first electrode formation film with the part located on the p-type active region left, and
the step (c) includes the steps of:
(c1) forming the second electrode formation film on the first electrode formation film and the gate insulating film; and
(c2) removing the second electrode formation film with the part located on the n-type active region left.

15. The semiconductor device manufacturing method of Claim 13,
wherein the step (b) includes the step of forming the first electrode formation film on each of the parts of the gate insulating film which are located on the p-type active region and the n-type active region, and
the step (c) includes the step of oxidizing a part of the first electrode formation film which is located on the n-type active region to form the second electrode formation film containing the metal element and having an oxygen content higher than the first electrode formation film.

16. The semiconductor device manufacturing method of Claim 15,
wherein in the step (c), the part of the first electrode formation film which is located on the n-type active region is oxidized by performing thermal treatment under an oxygen atmosphere.

17. The semiconductor device manufacturing method of Claim 15,
wherein in the step (c), the part of the first electrode formation film which is located on the n-type active region is oxidized by injecting an oxygen ion.

18. The semiconductor device manufacturing method of any one of Claims 13 to 17,
wherein the metal element is Ta.
